(19) Europäisches Patentamt
European Patent Office
Office européen des brevets

(11) Veröffentlichungsnummer: **0 027 932**
**B1**

# (12) EUROPÄISCHE PATENTSCHRIFT

(45) Veröffentlichungstag der Patentschrift: **18.05.83**

(51) Int. Cl.³: **G 03 C 5/24**, G 03 F 7/00, G 03 F 1/02

(21) Anmeldenummer: **80106128.4**

(22) Anmeldetag: **09.10.80**

(54) **Entwicklergemisch und Verfahren zum Entwickeln von belichteten lichtempfindlichen Kopierschichten.**

(30) Priorität: **17.10.79 DE 2941960**

(43) Veröffentlichungstag der Anmeldung: **06.05.81 Patentblatt 81/18**

(45) Bekanntmachung des Hinweises auf die Patenterteilung: **18.05.83 Patentblatt 83/20**

(84) Benannte Vertragsstaaten: **AT BE DE FR GB IT NL SE**

(56) Entgegenhaltungen: **DD-A-125 502**

(73) Patentinhaber: **HOECHST AKTIENGESELLSCHAFT, Postfach 80 03 20, D-6230 Frankfurt/Main 80 (DE)**

(72) Erfinder: **Sprintschnik, Gerhard, Dr., Mühlgasse 18, D-6238 Hofheim-Wallau (DE)**
Erfinder: **Neubauer, Rudolf, Dr., Goetheweg 3, D-6229 Erbach (DE)**
Erfinder: **Buhr, Gerhard, Dr., Am Erdbeerstein 28, D-6240 Königstein (DE)**

**EP 0 027 932 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Entwicklergemisch und Verfahren zum Entwickeln von belichteten lichtempfindlichen Kopierschichten

Die Erfindung betrifft ein Entwicklergemisch zum Entwickeln und ggf. Fixieren und Konservieren von belichteten lichtempfindlichen Schichten, insbesondere von vorsensibilisierten Flachdruckplatten. Im allgemeinen bestehen solche Schichten aus einer lichtempfindlichen Komponente (Diazoniumsalzkondensat, äthylenisch ungesättigte Verbindung, Azid oder dgl.) und einem meist nicht lichtempfindlichen polymeren wasserunlöslichen Bindemittel, welches der Kopierschicht gute drucktechnische Eigenschaften verleiht.

Schichten mit einem Gehalt an wasserunlöslichen Bindemitteln, insbesondere solchen, die auch in sauren oder alkalischen wässrigen Lösungen unlöslich sind, lassen sich nach bildmässiger Belichtung meist nur mit Entwicklerflüssigkeiten entwickeln, die relativ hohe Mengen niedrigsiedender, giftiger, feuergefährlicher und unangenehm riechender organischer Lösungsmittel enthalten. Die Verarbeitung solcher Entwickler stellt eine erhebliche Belastung der Umwelt dar und erfordert oft Vorkehrungen zur Beseitigung der Dämpfe und der verbrauchten Entwickler.

Die Wirkungsweise eines lösungsmittelhaltigen Entwickers lässt sich so verstehen, dass das Lösungsmittel das ungehärtete Bindemittel anquillt, wodurch ein mehr oder weniger mechanisches Herauslösen ermöglicht wird. Doch verkleben sehr oft die angequollenen Polymerpartikel rasch zu makroskopisch sichtbaren Fladen, welche wiederum an bereits entwickelten Teilen der Platte haften bleiben und dadurch Volltonflächen oder feine Rasterpartien der entwickelten Platte zukleben können, was in der Praxis als Redeponieren bezeichnet wird. Dadurch wird die Qualität der Druckplatte gemindert, und sie wird sogar für den Druck unbrauchbar. Eine Verarbeitung in Entwicklermaschinen erfordert oft die Anbringung spezieller Filtersysteme, welche die Fladen herausfiltrieren, um das Verkleben von Walzen zu verhindern. Meist lassen sich Fladenbildung und Redeponieren durch Erhöhung des Lösungsmittelanteils im Entwickler beseitigen, doch führt das zu den oben angegebenen Nachteilen.

Aus der DE-A-2 364 631 sind Entwickler für Schichten, die wasserunlösliche Polymere enthalten, bekannt. Diese Entwickler enthalten als bevorzugt wirksames Lösungsmittel Benzylalkohol. Sie sind für die dort beschriebenen speziellen Kopierschichten gut wirksam, jedoch im allgemeinen nicht zu einer breiteren Anwendung für verschiedenartige Druckplattentypen geeignet. Auch hier hat man versucht, den Gehalt an Benzylalkohol über seine Wasserlöslichkeit hinaus durch Zusatz von solubilisierenden, meist niedrigsiedenden Lösungsmitteln oder aber von Netzmitteln zu erhöhen. Dabei zeigte sich, dass der Zusatz von Netzmitteln in grösserer Menge zum Schäumen der Lösung führt und dadurch deren Verwendbarkeit in automatischen Verarbeitungsgeräten, z.B. solchen, die mit Sprühvorrichtungen arbeiten, beeinträchtigt.

Aus der DE-A-2 809 774 sind wässrige Entwicklerlösungen für Schichten aus Diazoniumsalz-Polykondensationsprodukten und wasserunlöslichen Polymeren bekannt, die anionische Netzmittel, Poly-N-vinyl-N-methyl-acetamid oder Polyvinylalkohol, Puffersalze, Benzylalkohol und Glycerintriacetat enthalten. Diese Entwickler sind ebenfalls für spezielle Schichten gut geeignet. Sie sind aber in ihrem Gehalt an Lösungsmitteln begrenzt und neigen bei höherem Netzmittelgehalt zum Schäumen.

Aufgabe der Erfindung war es, einen Entwickler bereitzustellen, der

1. frei ist von stark toxischen, unangenehmen riechenden, niedrigsiedenden Lösungsmitteln,
2. solche Lösungsmittel enthält, die praktisch geruchlos sind oder zumindest nicht unangenehm riechen und biologisch unbedenklich sind,
3. für eine sehr hohe Anzahl verschiedenster Bindemittelsysteme, wie sie für Hochauflagendruckplatten verwendet werden, anwendbar ist,
4. die belichtete Platte schnell, ohne Fladenbildung und Redeponierung bei geringem Entwicklerverbrauch entwickelt und
5. bei Anwendung in automatisch arbeitenden Entwicklungsmaschinen nicht zu stark schäumt.

Die Erfindung geht aus von einem Entwicklergemisch zum Entwickeln von belichteten lichtempfindlichen Kopierschichten, das ein Polymerisat eines N-Vinylamins, des Vinylalkohols oder eines Vinylalkoholderivats, einen in Wasser zu weniger als 10 Gew.-% löslichen Alkohol sowie Wasser als Hauptbestandteil enthält.

Das erfindungsgemässe Entwicklergemisch ist dadurch gekennzeichnet, dass es ein wasserlösliches oder in Wasser zu einer stabilen Dispersion dispergierbares Mischpolymerisat aus

a) hydrophilen Einheiten der Formel I

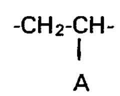 , I

worin A O-R oder 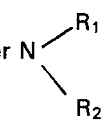 ,

R ein Wasserstoffatom oder eine Methylgruppe,
$R_1$ ein Wasserstoffatom, eine Alkylgruppe mit 1 bis 10 oder eine Alkoxyalkylgruppe mit 2 bis 10 Kohlenstoffatomen oder eine Arylgruppe mit 6 bis 10 Kohlenstoffatomen und
$R_2$ eine Alkylgruppe oder eine Acylgruppe mit jeweils 1 bis 5 Kohlenstoffatomen

bedeutet und wobei ein Homopolymerisat aus den hydrophilen Einheiten wasserlöslich ist, und

b) hydrophoben Einheiten von Vinylmonomeren, deren Homopolymerisat wasserunlöslich ist und die als Substituenten einen aromatischen oder einen langkettigen aliphatischen Rest aufweisen,

enthält, wobei der Mengenanteil der hydrophoben Einheiten so gross ist, dass eine 0,1%ige wässrige Lösung des Mischpolymerisats eine Oberflächenspannung von nicht mehr als 50 mN/m aufweist, und dass die Menge des Mischpolymerisats mindestens

ausreichend ist, um eine gegebenenfalls die Löslichkeitsgrenze überschreitende Menge des Alkohols zu emulgieren, wobei das Entwicklergemisch 1 bis 15 Gew.-% des in Wasser zu weniger als 10 Gew.-% löslichen Alkohols und 0,5 bis 10 Gew.-% des Mischpolymerisats enthält.

Die in den erfindungsgemässen Entwicklergemischen enthaltenen Mischpolymerisate aus hydrophilen und hydrophoben Einheiten sind entweder in Wasser löslich, z.B. zu 5 bis 10 Gew.-%, oder ohne Zusatz von Emulgatoren bzw. Dispergiermitteln in Wasser zu einer stabilen Dispersion dispergierbar.

Die hydrophilen Einheiten müssen so beschaffen sein, dass ihre Homopolymerisate wasserlöslich sind. Ausser ihnen und den hydrophoben Einheiten können die Polymerisate noch kleine Mengen, z.B. bis zu etwa 10%, andere Einheiten enthalten, die selbst wasserunlösliche Homopolymerisate bilden, aber die Oberflächenspannung nicht wesentlich herabsetzen, z.B. Einheiten von Vinylacetat oder niederen Alkylacrylaten.

Der Mengenanteil der hydrophilen Monomeren muss mindestens so hoch sein, dass die oben angegebene Löslichkeit bzw. Dispergierbarkeit in Wasser gewährleistet ist.

Als hydrophile Einheiten der oben angegebenen Formeln werden die Vinylaminderivate bevorzugt. Von diesen werden diejenigen bevorzugt, in denen $R_2$ eine Acylgruppe mit 1 bis 4 Kohlenstoffatomen ist.

$R_1$ ist bevorzugt Wasserstoff oder eine Alkylgruppe mit 1 bis 5 Kohlenstoffatomen.

Als hydrophobe Einheiten werden solche bevorzugt, die sich von Alkylestern ungesättigter Carbonsäuren mit 4 bis 30, vorzugsweise 6 bis 20 Kohlenstoffatomen in der Alkylgruppe, von vinylaromatischen Verbindungen oder von Vinylalkylestern mit 4 bis 30, vorzugsweise 6 bis 20 Kohlenstoffatomen in der Alkylgruppe ableiten. Als ungesättigte Carbonsäuren kommen insbesondere Acryl-, Methacryl- und Maleinsäure in Betracht. Der Mengenanteil des Mischpolymerisats an hydrophoben Monomereinheiten liegt im allgemeinen zwischen 0,5 und 25 Mol-%.

Die Herstellung von geeigneten Mischpolymerisaten ist z.B. in der US-A-3 284 429, der GB-A-1 082 016 und der DE-A-1 720 793 beschrieben, wobei beispielsweise ein Einsatz als Dispergierhilfsmittel für Olefine erwähnt wird.

Das Molekulargewicht der Mischpolymerisate hat keinen ausgeprägten Einfluss auf ihre Wirksamkeit. Im allgemeinen sollte es mindestens 1000, vorzugsweise 5000 bis 200 000 betragen.

Beispiele für Monomere, die geeignete hydrophobe Einheiten bilden, sind Versaticsäurevinylester, Isononansäurevinylester, Maleinsäuredihexylester, Ethylhexylacrylat, Decylmethacrylat, Laurylacrylat, Styrol und 4-Octylstyrol.

Die Mischpolymerisate werden dem Entwicklergemisch in Mengen von 0,5 bis 10%, bevorzugt 2 bis 7%, zugesetzt. Die Obergrenze ergibt sich aus der zu hohen Viskosität der fertigen Lösungen. Sie sollte einen Wert von 0,2 $cm^2/s$ bei 25°C, gemessen nach Übbelohde, nicht überschreiten.

Dem Entwickler können auch zusätzlich in geringer Menge (0,1-5%) andere wasserlösliche polymere Substanzen zugesetzt werden, z.B. Celluloseäther wie Methylcellulose, Carboxymethylcellulose, Hydroxyalkylcellulose, Salze und Ester der Alginsäure, Polyvinyllactame wie Polyvinylpyrrolidon und dessen Copolymere mit Vinylacetat, Polyacrylsäureamid, Polyvinylacetidinon, Polyvinylalkohol und wasserlösliche Homo- und Copolymere des N-Vinyl-N--methyl-acetamids, die nicht die Oberflächenspannung des Wassers in dem angegebenen Masse herabsetzen. Diese Polymeren müssen selbstverständlich im Entwickler beim jeweiligen pH-Wert mit den anderen Komponenten verträglich sein.

Als weiteren wesentlichen Bestandteil enthält das Entwicklergemisch mindestens einen in Wasser zu weniger als 10 Gew.-%, vorzugsweise zu weniger als 2 Gew.-% löslichen, vorzugsweise einwertigen Alkohol. Araliphatische oder cycloaliphatische Alkohole haben sich hierbei am besten bewährt, z.B. 1-Phenyl-äthanol, 2-Phenyl-äthanol, 3-Phenyl-propanol-1, 4-Phenyl-butanol-1, 4-Phenyl-butanol-2, 2-Phenyl-butanol-1, 2-Phenoxy-äthanol, 2-Benzyloxy-äthanol, o-Methoxy-benzylalkohol, m-Methoxy-benzylalkohol, p-Methoxy-benzylalkohol, Benzylalkohol, Cyclohexanol, 2-Methyl-cyclohexanol, 4-Methyl-cyclohexanol und 3-Methyl-cyclohexanol.

Aliphatische, insbesondere längerkettige Alkohole können auch verwendet werden, sind aber nicht so wirksam wie die araliphatischen Alkohole. Bei den aliphatischen Alkoholen sind primäre Alkohole besser geeignet als sekundäre oder tertiäre. Beispiele sind Butanol-1, Octanol-1, Ethylenglykolmonohexylether, Octanol-2, Octanol-4, 2-Ethyl-hexanol, Ethyl-hexylcarbinol, Citronellol, Geraniol.

Die Wirkung des Entwicklers kann so verstanden werden, dass der wenig wasserlösliche Alkohol durch das Mischpolymerisat solubilisiert wird. Auf diese Weise gelingt es, wenig wasserlösliche Alkohole sogar in so grossen Mengen in Wasser zu solubilisieren bzw. zu emulgieren, wie sie für einen technisch optimalen Entwickler nicht mehr benötigt werden. Beispielsweise besitzen Octanol-1 und 2-Phenoxy-ethanol bei Raumtemperatur eine Wasserlöslichkeit von weniger als 1 bzw. weniger als 2%, sind jedoch in Gegenwart von nur 5% eines Mischpolymerisats aus 9 Mol N-Vinyl-N-methyl--acetamid und 1 Mol Bis-(2-Ethyl-hexyl)-maleinat praktisch in beliebiger Menge in Wasser emulgierbar, wobei stabile Emulsionen entstehen, die sich selbst nach monatelanger Lagerung nicht absetzen.

Die Alkohole werden in Mengen von 1 bis 15, bevorzugt 2,5 bis 10 Gew.-%, dem Entwickler zugesetzt. Dabei lassen sich wirksame Entwickler in manchen Fällen bereits mit Alkoholmengen erhalten, die unterhalb der Löslichkeitsgrenze liegen. Die besten Wirkungen werden aber erzielt, wenn die zugesetzte Alkoholmenge dessen Löslichkeitsgrenze übersteigt und der überschüssige Anteil emulgiert ist.

Die Entwickler haben aufgrund ihrer Zusammensetzung meist ein opakes bis milchig undurchsichtiges Aussehen. Sie können zur Optimierung der Eigenschaften zusätzlich Netzmittel, Salze, Weichmacher, Säuren, Alkali, Duftstoffe, die oben erwähnten wasserlöslichen Polymeren und andere organische Lösungsmittel enthalten. Die Menge muss jeweils so

bemessen sein, dass die Komponenten untereinander verträglich bleiben und es nicht zu Ausfällungen, Phasentrennungen usw. kommt.

Aus der Klasse der Netzmittel werden anionische, wie Natriumlaurylsulfat, Natriumoctylsulfat, Natriumsalze entsprechend substituierter Sulfonbernsteinsäureester, Natriumisopropylnaphthalinsulfonat, Natriumölsäuresarkosid, Natriumölsäureisethionat, Natriumölsäuremethyltaurid, Natriumfettalkoholpolyglykolethersulfat, Natriumfettalkylphenolpolyglykolethersulfat, Natriumfettolefinsulfonat, Natriumfettalkylphenolsulfonat oder Gemische davon und kationische, wie N-Cetylpyridiniumchlorid, Trimethylstearylammoniumhalogenide und Fettalkylbenzyldimethylammoniumchlorid, bevorzugt. Es können aber auch nichtionogene Netzmittel, z.B. Alkylphenol- oder Fettalkoholpolyglykolether verwendet werden. Diese genannten oberflächenaktiven Substanzen bewirken eine zusätzliche Stabilisierung der Emulsion auch bei relativ geringem Gehalt an emulgierendem Mischpolymerisat. Die Menge der Netzmittel sollte so klein gehalten werden, dass die Emulsion unter den Bedingungen der Entwicklung nicht schäumt. Sie liegt zwischen 0,05 und 5 Gew.-%.

Als Salze können z.B. wasserlösliche Alkali- und Erdalkaliphosphate, -sulfate, -chloride, -nitrate, -silikate, -carbonate, -borate, -acetate und -benzoate zugesetzt werden. Ihre Menge beträgt 0,1 bis 10 Gew.-%.

Als Säuren können z.B. Phosphorsäure, Weinsäure, p-Toluolsulfonsäure und Citronensäure in Mengen von 0,1 bis 8 Gew.-% zugesetzt werden.

Als weitere, von den oben beschriebenen Alkoholen verschiedene organische Lösungsmittel werden im allgemeinen höhersiedende polare Lösungsmittel verwendet, d.h. solche, deren Siedepunkt mindestens im gleichen Bereich liegt wie der des Alkohols. Geeignet sind u.a. zu mehr als 10% in Wasser lösliche Lösungsmittel, z.B. mehrwertige Alkohole sowie deren Partialether und Ester, entsprechende Derivate der Glykolsäuren und Triethanolamin. Ferner sind wasserunlösliche Lösungsmittel, die keine Hydroxygruppen enthalten, z.B. vollständig veretherte oder veresterte ein- oder bevorzugt mehrwertige Alkohole, wie Glycerintriacetat, Phthalsäuredibutylester und Dialkylester von Ethylenglykol geeignet. Unter diesen organischen Lösungsmitteln sind die gegebenenfalls mindestens partiell veretherten oder veresterten mehrwertigen Alkohole bevorzugt. Die zusätzlichen Lösungsmittel werden in einer Menge von 0,1 bis 10, vorzugsweise 2 bis 6 Gew.-% zugesetzt. Es wird angenommen, dass diese organischen Lösungsmittel am eigentlichen Entwicklungsvorgang nicht oder nur in untergeordnetem Masse beteiligt sind; sie dienen im wesentlichen der Feuchthaltung bzw. Weichmachung beim Eintrocknen der Entwickler auf den zu ihrem Auftrag verwendeten Plüschtampons oder Plüsch- und Bürstleisten in Entwicklungsvorrichtungen.

Die erfindungsgemässen Entwicklergemische sind für eine Vielzahl von unterschiedlichen lichtempfindlichen Schichten sehr gut wirksam, indem sie die ungehärteten Schichtbestandteile auch aus feinsten Rasterpartien sehr rasch anquellen und vollständig dispergieren, ohne die gehärteten Schichtbestandteile anzugreifen oder zu beschädigen. Es kommt nicht zur Bildung von störenden Fladen oder Redeponierungen in Volltonflächen oder feinen Rasterpartien. Offenbar bewirkt das hydrophil/hydrophobe Mischpolymerisat eine bessere und stabilere Dispergierung der nicht molekulardispers gelösten Schichtbestandteile.

Stellt man hingegen Entwickler ohne die Mischpolymerisate her, benötigt man zusätzliche Mengen an oberflächenaktiven Substanzen, um das Lösungsmittel in Wasser zu solubilisieren, die dazu führen kann, dass sich starke Schaumbildung störend bemerkbar macht, oder dass der Entwickler zu aggressiv wird. Entwickler dieser Art sind zwar ebenfalls in der Lage, ungehärtete Schichtbestandteile anzuquellen und abzulösen, können aber in vielen Fällen das Koagulieren und Ausflocken unlöslicher Schichtbestandteile nicht verhindern, so dass es zu Redeponierungen kommt. Verzichtet man andererseits vollkommen auf das Lösungsmittel, nicht aber auf den Polymerbestandteil des erfindungsgemässen Entwicklergemisches, so ist das Anquellungsvermögen des Entwicklers zu gering. Ein solcher Entwickler ist unwirksam.

Bevorzugt werden die erfindungsgemässen Entwicklergemische für negativ arbeitende Schichten angewandt, die vorwiegend aus einem Diazopolykondensat und einem wasserunlöslichen polymeren Bindemittel bestehen. Aber auch belichtete photopolymerisierbare Kopierschichten lassen sich mit diesen Gemischen entwickeln. Geeignete Bindemittel für derartige Schichten sind polymere Vinylester, z.B. Polyvinylacetat, Polyvinylpropionat, Polyvinylbenzoat, Polyvinylisononanat, Polyvinylversatat, Polyvinylchlorid, Polyvinylidenchlorid sowie teilverseifte Derivate der angegebenen Polymeren; polymere Acryl- und Methacrylsäureester, wobei die Alkoholkomponente 1 bis 20 C-Atome enthalten kann; Polyvinylacetale wie Polyvinylformal, Polyvinylbutyral, Polyvinylbenzal, die noch unterschiedliche Mengen an OH- und Acetatgruppen enthalten können; Mischpolymerisate der oben genannten Substanzklassen, z.B. mit Crotonsäure, Maleinsäure- und Fumarsäureestern, Acrylsäure und Methacrylsäure; Homopolymerisate des Styrols oder Mischpolymerisate mit den oben genannten Monomeren; modifizierte und nichtmodifizierte Epoxidharze, z.B. solche, deren freie Epoxidgruppen mit organischen oder anorganischen Säuren umgesetzt worden sind; Phenol- und Kresol-Formaldehydharze, Harnstoff-Formaldehyd-Harze, Melamin-Formaldehydharze, Polyurethanharze, und zwar sowohl verzweigte als auch lineare sowie Polyurethane mit endständigen Isocyanatgruppen; Mischpolymerisate von reaktiven Monomeren wie N-Methylol-acrylamid oder Acetoacetyläthylacrylat mit Vinylestern, Acrylaten, Methacrylaten und dgl., Alkydharze, Polyamidharze, Polycarbonate und Polyäthylenharze, auch solche, die mit Carboxylgruppen modifiziert sind.

Die Kombination solcher Bindemittel mit lichtempfindlichen Komponenten zu lichtempfindlichen Schichten ist dem Fachmann bekannt. Diese Schichten enthalten üblicherweise noch Pigmente, Farbstoffe, Indikatoren, Säuren, Weichmacher, wasserlösliche Polymere, oberflächenaktive Substanzen und dgl. Diese Zusätze sind dem Fachmann ebenfalls bekannt. Geeignete Schichten sind z.B. in den DE-A-2 024 244, 2 034 654, 2 034 655, 2 039 861, 2 331 377, 2 739 774, 2 822 887, 2 834 059 und der US-A-3 660 097 beschrieben.

Als Schichtträger kommen in der Regel die für Druckplatten üblichen Materialien in Frage wie Papier, Kunststoffolien, Aluminium, Kupfer, Zink, Stahl u.ä. Besonders bevorzugt wird Aluminium, das für diesen Zweck üblicherweise mechanisch, chemisch oder elektrochemisch aufgerauht und anschliessend gegebenenfalls anodisch oxydiert worden ist. Eine weitere Behandlung dieses Trägermaterials mit Polyvinylphosphonsäure, Phosphat, Silikat, Hexafluorozirkonat, Chromat, Borat, Polyacrylamid, Cellulosederivaten oder dgl. kann vorteilhaft sein.

Neben ihrer guten Entwicklungswirkung haben die erfindungsgemässen Gemische weitere vorteilhafte Eigenschaften, die bei der Verarbeitung lichtempfindlicher Druckplatten genutzt werden können. So können die Gemische nach beendeter Entwicklung auf der Plattenoberfläche antrocknen gelassen oder getrocknet, z.B. eingerieben werden. Sie wirken dann als Konservierungsmittel für die Plattenoberfläche, so dass die Anwendung eines zusätzlichen Konservierungsmittels, wie Gummi arabicum, überflüssig ist.

Sie haben weiterhin den Vorteil, dass sie die Ablagerung von unlöslichen Harzen in Entwicklungsmaschinen wirksam verhindern. Bei bekannten Entwicklern stellten derartige Ablagerungen ein erhebliches Problem dar, wenn sie an unzugänglichen Stellen der Maschine erfolgten. Die erfindungsgemässen Gemische sind sogar befähigt, aus Maschinen, die solche Ablagerungen enthalten, diese zu entfernen, ohne dass dabei eine Verunreinigung oder Beschädigung einer gleichzeitig darin entwickelten Druckplatte erfolgt. Die Gemische sind somit auch allgemein als Reinigungsmittel für Materialien und Gegenstände aller Art von hydrophoben wasserunlöslichen Verunreinigungen, z.B. Fetten, Harzen, Silikonen, Farbstoffen und dgl., geeignet.

In den folgenden Ausführungsbeispielen werden bevorzugte Ausführungsformen der Erfindung beschrieben. Mengenverhältnisse, Prozentangaben und Teile sind in Gewichtseinheiten zu verstehen, wenn nicht anderes angegeben ist. Die Oberflächenspannungen sind bei 25°C gemessen worden.

*Beispiel 1*

1 g eines Polykondensats aus 1 Mol 3-Methoxy-diphenylamin-4-diazoniumchlorid und 1 Mol 4,4'-Bis-methoxymethyl-diphenyläther, ausgefällt als Mesitylensulfonat, 4 g eines Mischpolymerisats aus Vinylacetat und Dibutylmaleinat, 0,4 g Malachitgrün (C.I. 42000), 0,1 g Phosphorsäure (85%ig) und 0,1 g Metanilgelb (C.I. 13065) wurden in 150 ml Äthylenglykolmonomethyläther und 50 ml Tetrahydrofuran gelöst und auf einen Schichtträger derart aufgebracht, dass die getrocknete Schicht ein Gewicht von 0,8 g/m$^2$ hatte. Der Schichtträger bestand aus elektrochemisch aufgerauhtem und anodisch oxydiertem Aluminium mit einem Oxidgewicht von 3 g/m$^2$ und war mit einer wässrigen Lösung von Polyvinylphosphonsäure nachbehandelt worden.

Die erhaltene Offsetplatte wurde unter einer Negativvorlage in einem handelsüblichen Belichtungsgerät mit einer Metallhalogenidlampe von 5000 W 30 Sekunden belichtet und durch Aufgiessen einer Mischung aus 100 g Wasser, 4,5 g 4-Phenyl-butanol-2, 5 g eines Mischpolymerisats aus N-Vinyl-N-methyl-acetamid und Dioctylmaleinat (88 : 12), 0,5 g Phosphorsäure (85%ig), 0,2 g Natriumoctylsulfat und 3 g Magnesiumsulfat entwickelt. Eine 0,1%ige wässrige Lösung des Mischpolymerisats hatte die Oberflächenspannung 33 mN/m. Die Platte war nach Abbrausen mit Wasser gebrauchsfertig für die Druckmaschine. Weder in Volltonflächen noch in feinen Raster- oder Strichelementen fanden sich Redeponierungen oder unentwickelte Schichtreste.

Eine weitere in gleicher Weise entwickelte Platte wurde nach dem Abbrausen mit frischer Entwicklerlösung übergossen und mit einem Tampon trockengerieben. Nach vier Wochen wurde die Platte wiederum mit Wasser abgebraust und zeigte das gleiche Druckverhalten wie die unmittelbar nach der Entwicklung verwendete Platte.

Zum Vergleich wurde Beispiel 1 wiederholt, wobei das Mischpolymerisat im Entwickler durch die gleiche Menge Poly-N-Vinyl-N-methyl-acetamid ersetzt wurde. Die Entwicklungswirkung war praktisch gleichwertig, doch wurden in feinen Rasterpartien und auf Volltonflächen des Bilds erhebliche Mengen oleophiler Flocken redeponiert. Eine 0,1%ige wässrige Lösung des Homopolymerisats hatte die Oberflächenspannung 60 mN/m.

*Beispiel 2*

1 g eines Polykondensats aus 1 Mol 3-Methoxydiphenylamin-4-diazoniumchlorid und 1 Mol 4,4'-Bis-methoxymethyl-diphenyläther, ausgefällt als Methansulfonat, 8 g eines Mischpolymerisats aus Butylacrylat und Vinylacetat (Molverhältnis 1 : 1), 0,3 g Viktoriareinblau FGA (C.I. Basic Blue 81), 0,2 g Phosphorsäure (85%ig) wurden in 200 ml Äthylenglykolmonomethyläther gelöst und auf einen Aluminiumträger derart aufgetragen, dass das Gewicht der trockenen Schicht 1 g/m$^2$ betrug. Der Schichtträger war durch Bürsten mit einer wässrigen Schleifmittelsuspension aufgerauht und danach mit einer wässrigen Lösung von Polyvinylphosphonsäure behandelt worden. Nach bildmässiger Belichtung wie in Beispiel 1 wurde mit einer Mischung aus 100 g Wasser, 10 g Octanol-1, 1,5 g Na-octylsulfat, 0,4 g Natriummetasilikat, 3 g eines wasserlöslichen Mischpolymerisats aus N-Vinyl-N-methyl-acetamid und Äthensulfonsäure (Molverhältnis 3 : 2) und 3 g eines Mischpolymerisats aus N-Vinyl-N-methyl-acetamid und 2-Äthyl-hexylacrylat (91 : 9) entwickelt.

*Beispiel 3*

1 g des Diazopolykondensats aus Beispiel 1, 4 g einer wässrigen 50%igen Polyvinylbutyraldispersion, 5 g einer Pigmentdispersion — bestehend aus 10% eine -Cu-Phthalocyanins (C.I. 74160), 10% Polyvinylformal und 80% Äthylenglykolmethylätheracetat und 0,2 g Methylorgane wurden in 80 g Cyclohexanon und 40 g Tetrahydrofuran gelöst und

wie in Beispiel 1 auf den dort beschriebenen Schichtträger aufgetragen. Die Entwicklung erfolgte mit einer Lösung aus 100 g Wasser, 7 g m-Methoxybenzylalkohol, 6 g eines Mischpolymerisats aus Vinylalkohol, Vinylacetat und Vinylversatat (Molverhältnis 94 : 5 : 1), 1,1 g Natriumoctylsulfat und 2 g Phosphorsäure (85%ig). Es wurde eine Druckplatte erhalten, die in der Druckmaschine eine sehr hohe Auflage lieferte. Eine 0,1%ige wässrige Lösung des Mischpolymerisats hatte die Oberflächenspannung 44 mN/m.

*Beispiel 4*

1,15 g des Diazopolykondensats aus Beispiel 1, 3,45 g eines Mischpolymerisats aus Methylmethacrylat und Methacrylsäure mit der Säurezahl 110, 1 g der in Beispiel 3 angegebenen Pigmentdispersion, 0,1 g Phosphorsäure (85%ig) und 0,04 g Metanilgelb wurden in 100 g Äthylenglykolmonomethyläther gelöst und auf den in Beispiel 2 angegebenen Schichtträger zu einem Trockenschichtgewicht von 0,8 g/m$^2$ aufgebracht. Nach bildmässiger Belichtung erfolgte die Entwicklung mit einer Lösung aus 5 Teilen Benzylalkohol, 4 Teilen Phosphorsäure (85%ig), 5 Teilen des in Beispiel 1 angegebenen Mischpolymerisats von N-Vinyl-N-methyl-acetamid und 1 Teil Natriumoctylsulfat in 100 Teilen Wasser. Es wurde eine einwandfrei entwickelte Druckplatte erhalten, die in einer Bogenoffsetdruckmaschine 20 000 bis 30 000 gute Drucke lieferte.

*Beispiel 5*

2,4 g des Diazokondensats aus Beispiel 1, 28,8 g einer 65%igen Lösung eines nichtplastifizierten, mittelviskosen Harnstoffharzes (in Butanol), 0,45 g Phosphorsäure (85%ig) und 1,2 g Viktoriareinblau FGA (C.I. Basic Blue 81) urden in 300 ml Äthylenglykolmonomethyläther gelöstund derart auf den in Beispiel 2 angegebenen Schichtträger aufgebracht, dass das Gewicht der trockenen Schicht 1,4 g/m$^2$ betrug. Nach bildmässiger Belichtung wurde mit einer Mischung aus 100 Teilen Wasser, 5 Teilen o-Methoxy-benzylalkohol, 3 Teilen des in Beispiel 1 angegebenen Mischpolymerisats, 2 Teilen Phosphorsäure (85%ig) und 1 Teil Natriumoctylsulfat zügig und fladenfrei entwickelt.

*Beispiel 6*

8 g einer 50%igen wasserverdünnbaren Lösung eines mittelöligen Alkylharzes auf Basis trocknender Fettsäuren mit der Säurezahl 45 in Butanol (dynamische Viskosität der Lösung bei 20°C 160-250 mPa · s), 2 g des in Beispiel 1 beschriebenen Diazokondensats, 0,2 g Phosphorsäure (85%ig) und 0,3g Fuchsin (C.I. 42510) wurden in 150 ml Äthylenglykolmonomethyläther und 50 ml Tetrahydrofuran gelöst und auf den in Beispiel 2 beschriebenen Schichtträger derart aufgebracht, dass das Gewicht der trockenen Schicht 1 g/m$^2$ betrug. Nach bildmässiger Belichtung wurde mit einer Lösung aus 4 Teilen 1-Phenyl-äthanol, 0,3 Teilen Natriummetasilikat, 2 Teilen eines Natriumfettalkoholpolyglykoläthersulfats und 3 Teilen eines Mischpolymerisats aus N-Vinyl-N-methyl-acetamid und 2-Äthylhexylacrylat (91 : 9), 3 Teilen Trinatriumphosphat und 100 Teilen Wasser zügig und vollständig entwickelt.

*Beispiel 7*

1,15 g des in Beispiel 1 angegebenen Diazokondensationsprodukts, 3,45 g eines im wesentlichen linearen Polyurethans, hergestellt aus 4,4'-Diphenylmethan-diisocyanat und einem Polyesterdiol aus Adipinsäure und Butandiol-1,4, 1 g der in Beispiel 3 angegebenen Pigmentdispersion, 0,04 g Metanilgelb und 0,1 g Phosphorsäure (85%ig) wurden in 100 ml Äthylenglykolmonomethyläther gelöst und auf den in Beispiel 2 beschriebenen Schichtträger derart aufgetragen, dass das Gewicht der trockenen Schicht 1 g/m$^2$ betrug. Nach bildmässiger Belichtung wurde mit einer Mischung aus 83 g Wasser, 5 g 4-Phenyl-butanol-1, 1 g Natriumoctylsulfat und 5 g des in Beispiel 1 angegebenen Mischpolymerisats entwickelt. Es wurde eine sauber entwickelte Druckplatte erhalten, die in einer Bogenoffsetmaschine ca. 15 000 einwandfreie Drucke lieferte.

*Beispiel 8*

3 g Polyvinylformal mit einem Molekulargewicht von ca. 30 000, einem Hydroxylgruppengehalt von 6% und einem Acetatgruppengehalt von 26%, 1 g des Diazokondensats aus Beispiel 2, 0,3 g Phosphorsäure (85%ig), 0,4 g Viktoriareinblau FGA und 0,2 g Metanilgelb wurden in 100 ml Äthylenglykolmonomethyläther gelöst und derart auf den in Beispiel 2 beschriebenen Schichtträger aufgetragen, dass das Schichtgewicht 0,5 g/m$^2$ betrug. Nach bildmässiger Belichtung wurde mit dem in Beispiel 4 beschriebenen Entwickler, in dem der Benzylalkohol durch die gleiche Menge 2-Phenoxy-äthanol ersetzt worden war, entwickelt und eine einwandfreie Druckplatte erhalten.

*Beispiel 9*

Es wurde verfahren wie in Beispiel 7, nur dass anstelle des Polyurethanbindemittels die gleiche Menge eines Gemisches eines mittelviskosen nichtplastifizierten Harnstoffharzes in Form einer 65%igen Lösung in Butanol, Viskosität der Lieferform 3000 bis 3600 mPa · s bei 20°C, mit einem nichtmodifizierten Epoxidharz mit dem Erweichungspunkt von 65 bis 75°C und dem Epoxidäquivalentgewicht 450 bis 525 eingesetzt wurde. Das Gewichtsverhältnis der Harze, auf Festsubstanz bezogen, war 1 : 1. Auf dem in Beispiel 2 beschriebenen Schichtträger wurde eine Schicht erhalten, die nach bildmässiger Belichtung mit dem in Beispiel 7 beschriebenen Entwickler entwickelt wurde und in einer Offsetmaschine ca. 15 000 gute Drucke lieferte.

*Beispiel 10*

8 g einer 50%igen Lösung eines hydroxylgruppenhaltigen Acrylharzes (Hydroxylgruppengehalt 4,8%) in Xylol/Äthylenglykoläthylätheracetat (2 : 1) mit einer dynamischen Viskosität bei 25°C von 1550 mPa · s, 2 g einer 56%igen wässrigen Dispersion eines Mischpolymerisats aus Vinylacetat und Butylacrylat (Molverhältnis 1 : 1), 2 g des in Beispiel 1 beschriebenen Diazokondensats, 0,5 g Malachitgrün, 0,2 g Phosphorsäure (85%ig) und 0,2 g Methylorange wurden in 150 ml Äthylenglykolmonomethyläther und 50 ml Tetrahydrofuran gelöst und auf den in Beispiel 1 beschriebenen Schichtträger derart aufgebracht, dass das Gewicht der trockenen Schicht 1,3 $g/m^2$ betrug. Nach bildmässiger Belichtung wurde mit einer wässrigen Lösung von 5% eines Mischpolymerisats aus N-Methyl-N-vinyl-acetamid und 2-Äthyl-hexylacrylat (91 : 9), 5% m-Methoxy-benzylalkohol, 0,2% Natriumoctylsulfat und 2% Phosphorsäure (85%ig) entwickelt. Es wurde eine einwandfrei entwickelte Druckplatte erhalten.

*Beispiel 11*

8 g eines Epoxidharzes mit einem Epoxidäquivalentgewicht von 450 - 525, 2 g eines Kondensationsproduktes aus Diphenylamin-4-diazoniumchlorid und Formaldehyd, ausgefällt als 2-Hydroxy-3-methoxy-benzophenon-4-sulfonat, 0,2 g Phosphorsäure (85%ig) und 0,3 g Fuchsin wurden in 200 ml eines Gemisches aus Äthylenglykolmonomethyläther/Tetrahydrofuran (3 : 1) gelöst und auf einen Schichtträger derart aufgebracht, dass das Schichtgewicht 1 $g/m^2$ betrug. Der Schichtträger bestand aus einer Aluminiumfolie, deren Oberfläche durch Drahtbürsten aufgerauht und dann mit einer wässrigen Lösung von Polyvinylphosphonsäure behandelt worden war. Nach bildmässiger Belichtung wurde mit einer Mischung aus 100 g Wasser, 5 g 2-Phenyl-äthanol, 5 g eines Mischpolymerisats aus N-Vinyl-N-methyl-acetamid und Octylacrylat (91 : 9) und 0,3 g Natriummetasilikat entwickelt.

*Beispiel 12*

1,15 g des in Beispiel 1 beschriebenen Diazopolykondensats, 3,45 g Polyurethanpräpolymeren mit endständigen freien Isocyanatgruppen, hergestellt aus 8 Mol 2,4-Tolylendiisocyanat, 1 Mol Butandiol-1,4, 1 Mol Polypropylenglykol (MG = 1000) und 2 Mol 1,1,1-Trimethylol-propan, 1,0 g der Pigmentdispersion aus Beispiel 3, 0,04 g Metanilgelb und 0,2 g Phosphorsäure (85%ig) wurden in 100 ml Äthylenglykolmonomethyläther gelöst und auf den in Beispiel 2 angegebenen Schichtträger derart aufgetragen, dass das Gewicht der trockenen Schicht 1 $g/m^2$ betrug. Nach bildmässiger Belichtung wurde mit dem Entwickler des Beispiels 7 entwickelt und eine einwandfrei entwickelte Druckplatte erhalten, die 60 000 gute Drucke lieferte.

*Beispiel 13*

10 g einer 50%igen wässrigen Dispersion eines Terpolymerisats aus Äthylen, Vinylacetat und Vinylchlorid, 1,5 g des Diazopolykondensats aus Beispiel 1, 0,3 g Phosphorsäure (85%ig) und 0,1 g Viktoriareinblau FGA wurden in 100 ml eines Gemisches aus Äthylenglykolmonomethyläther, Tetrahydrofuran und Butylacetat (4 : 5 : 1) gelöst und auf den in Beispiel 1 beschriebenen Schichtträger so aufgebracht, dass das Gewicht der trockenen Schicht 1,3 $g/m^2$ betrug. Es wurde nach bildmässiger Belichtung mit einer wässrigen Lösung von 7% eines Mischpolymerisats aus N-Vinyl-N-methyl-acetamid und Bis-(2-äthyl-hexyl)-maleinat (88 : 12), 2% Phosphorsäure, 1% Magnesiumsulfat und 6% 4-Methoxy-benzylalkohol und 3% Äthylenglykol entwickelt und eine einwandfrei entwickelte Druckplatte erhalten.

Die Platte liess sich auch in einer handelsüblichen Entwicklungsmaschine einwandfrei entwickeln, die zuvor über längere Zeit mit einem üblichen Entwickler betrieben worden war. In dieser Maschine hatten sich an schwer zugänglichen Stellen Rückstände von wasserunlöslichen Konsensations- oder Polyvinylharzen abgesetzt. Diese Rückstände wurden durch den erfindungsgemässen Entwickler abgelöst, ohne dass es zu einer nennenswerten Beeinträchtigung der Qualität der entwickelten Platte kam.

*Beispiel 14*

6 g einer wässrigen Dispersion eines Terpolymerisats aus Vinylacetat, Vinylversatat und Butylacrylat (50% Feststoff), 0,4 Malachitgrün, 0,2 g Phosphorsäure und 1 g des Diazokondensats aus Beispiel 2 wurden in 150 ml eines Gemisches aus Cyclohexanon, Tetrahydrofuran und Butylacetat (5 : 4 : 1) gelöst und derart auf den in Beispiel 1 beschriebenen Aluminiumträger aufgetragen, dass das Gewicht der trockenen Schicht 0,7 $g/m^2$ betrug. Nach bildmässiger Belichtung wurde mit einer wässrigen Lösung entwickelt, die 7% 3-Phenyl-propanol-1, 3,8% eines Mischpolymerisats aus 2-Äthyl-hexylacrylat und N-Vinyl-N-methyl-acetamid (91 : 9), 3% Phosphorsäure (85%ig) und 0,5% Natriumlaurylsulfat enthielt. Es wurde eine einwandfrei entwickelte Druckplatte erhalten, die in einer Bogenoffsetmaschine über 100 000 gute Drucke lieferte.

*Beispiel 15*

Eine Lösung von 1,4 g eines Mischpolymerisats aus Methylmethacrylat und Methacrylsäure mit der Säurezahl 105, 1,4 g Trimethyloläthantriacrylat, 0,4 g 1,6-Dihydroxy-äthoxy-hexan und 0,05 g Benz-(a)-acridin in 13 g Äthylenglykolmonomethyläther wurde filtriert und auf elektrolytisch aufgerauhtes und anodisch oxydiertes Aluminium mit einem Oxidschichtgewicht von 3 $g/m^2$ in solcher Menge aufgebracht, dass nach dem Trocknen ein Schichtgewicht von 5 $g/m^2$ erhalten wurde.

Die Platte wurde bildmässig belichtet und mit einer Lösung von 3 g Natriummetasilikat, 0,05 g Strontiumchlorid, 0,3 g Natrumlaurylsulfat, 2 g eines Mischpolymerisats aus N-Vinyl-N-methyl-acetamid und Octylacrylat (91 : 9) und 3 g 2-Phenoxy-äthanol in 100 g Wasser entwickelt. Eine 0,1%ige wässrige Lösung des Mischpolymerisats hatte die Oberflächenspannung 39 mN/m. Es wurde eine einwandfrei entwickelte Offsetdruckform erhalten, die über 100 000 Drucke lieferte.

*Beispiel 16*

8 g einer weichgemachten Polyvinylacetatdispersion (Feststoff 60%) mit einem Celluloseäther als Schutzkolloid, 1 g einer 40%igen Dispersion von Pigment Green 7 (C.I. 74260) in Äthylenglykol/Wasser (3 : 1), 1 g des Diazokondensats aus Beispiel 1 und 0,3 g Phosphorsäure (85%ig) wurden in 100 ml Äthylenglykolmonomethyläther gelöst und derart auf einen elektrochemisch aufgerauhten und mit Natriumsilikatlösung behandelten Schichtträger aus Aluminium aufgebracht, dass das Gewicht der

trockenen Schicht 1 g/m² betrug. Nach bildmässiger Belichtung wurde mit einem Entwickler folgender Zusammensetzung entwickelt: 100 g Wasser, 2,8 g des in Beispiel 1 angegebenen Mischpolymerisats, 4,5 g 2-Phenyl-1-butanol und 5 g Dinatriumphosphat. Die Platte liess sich zügig und fladenfrei entwickeln und lieferte in einer Druckmaschine viele 1000 gute Drucke.

*Beispiel 17*

0,76 g des Veresterungsproduktes aus 1 Mol 2,3,4-Trihydroxy-benzophenon und 3 Mol Naphthochinon-(1,2)-diazid-(2)-5-sulfonsäurechlorid, 0,58 g des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid, 0,19 g Naphthochinon-(1,2)-diazid-(2)-4-sulfonsäurechlorid, 5,85 g eines Kresol-Formaldehyd-Novolaks mit einem Erweichungspunkt von 105 - 120°C und 0,07 g Kristallviolett (C.I. 42555) wurden gelöst in einem Gemisch aus 40 g Äthylenglykolmonomethyläther, 50 g Tetrahydrofuran und 10 g Butylacetat. Die Lösung wurde derart auf den in Beispiel 1 beschriebenen Aluminiumträger aufgebracht, dass das Gewicht der trockenen Schicht 1,0 g/m² betrug. Nach bildmässiger Belichtung wurde mit einer wässrigen Lösung entwickelt, die 4% Benzylalkohol, 2% Triäthanolamin, 3% des in Beispiel 1 angegebenen Mischpolymerisats, 3% Natriumsulfat, 0,2% Natriummetasilikat, 2% tertiäres Natriumphosphat und 1% Natriumoctylsulfat enthielt. Es wurde eine einwandfreie Druckplatte erhalten, die in einer Bogenoffsetmaschine mehr als 100 000 Drucke lieferte.

*Beispiel 18*

3 g des in Beispiel 1 beschriebenen Diazokondensats, 1 g eines Pigmentpulvers, hergestellt aus β-Cu-Phthalocyanin und Polyvinylbutyral (1 : 1), 1 g Phosphorsäure und 0,1 g Metanilgelb wurden in 100 ml Äthylenglykolmonomethyläther gelöst und auf einen Schichtträger so aufgetragen, dass das Schichtgewicht 0,5 g/m² betrug. Der Schichtträger unterschied sich von dem in Beispiel 1 beschriebenen nur durch das geringere Oxidgewicht von 2 g/m². Nach bildmässiger Belichtung wurde die Platte in eine Küvette getaucht, die den in Beispiel 10 beschriebenen Entwickler enthielt. Nach etwa einer halben Minute wurde die Platte herausgenommen und kurz mit Wasser abgebraust. Mit der so verarbeiteten Platte liessen sich in einer Druckmaschine mit Alkoholfeuchtwerk ca. 100 000 Bogen drucken.

*Beispiel 19*

Es wurden 6 g einer 50%igen wässrigen Dispersion eines Terpolymerisats aus Äthylen, Vinylacetat und Vinylchlorid, 1,5 g des Diazopolykondensats aus Beispiel 1, 0,08 g Phosphorsäure (85%ig), 0,16 g Viktoriareinblau FGA und 0,11 g Metanilgelb in einem Gemisch aus 116 g Äthylenglykolmonomethyläther, 59 g Tetrahydrofuran und 17 g Butylacetat gelöst und auf den in Beispiel 1 beschriebenen Schichtträger so aufgebracht, dass das Gewicht der trockenen Schicht 0,8 g/m² betrug. Nach bildmässiger Belichtung wurde mit einer wässrigen Lösung von 2,9% eines Mischpolymerisats aus N-Methyl-N-vinyl-acetamid und Bis-(2-äthyl-hexyl)-maleinat (88 : 12), 3% Dinatriumhydrogenphosphat, 4,3% Benzylalkohol 0,2% Natriumoctylsulfat und 4,0% Diäthylenglykol entwickelt und eine einwandfreie Druckplatte erhalten, die in einer Bogenoffsetdruckmaschine mehr als 100 000 gute Drucke lieferte.

**Patentansprüche**

1. Entwicklergemisch zum Auswaschen von bildmässig belichteten lichtempfindlichen Kopierschichten, enthaltend ein Polymerisat eines N-Vinylamins, des Vinylalkohols oder eines Vinylalkoholderivats, einen in Wasser zu weniger als 10 Gew.-% löslichen Alkohol sowie Wasser als Hauptbestandteil, dadurch gekennzeichnet, dass es ein wasserlösliches oder in Wasser zu einer stabilen Dispersion dispergierbares Mischpolymerisat aus

a) hydrophilen Einheiten der Formel I

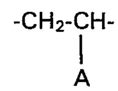 , I

worin A O-R oder 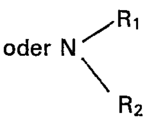 ,

R ein Wasserstoffatom oder eine Methylgruppe,
$R_1$ ein Wasserstoffatom, eine Alkylgruppe oder eine Alkoxyalkylgruppe mit jeweils 1 bis 10 Kohlenstoffatomen oder eine Arylgruppe mit 6 bis 10 Kohlenstoffatomen und
$R_2$ eine Alkylgruppe oder eine Acylgruppe mit jeweils 1 bis 5 Kohlenstoffatomen

bedeutet und wobei ein Homopolymerisat aus den hydrophilen Einheiten wasserlöslich ist, und

b) hydrophoben Einheiten von Vinylmonomeren, deren Homopolymerisat wasserunlöslich ist und die als Substituenten einen aromatischen oder einen langkettigen aliphatischen Rest aufweisen,

enthält, wobei der Mengenanteil der hydrophoben Einheiten so gross ist, dass eine 0,1%ige wässrige Lösung des Mischpolymerisats eine Oberflächenspannung von nicht mehr als 50 mN/m aufweist, und dass die Menge des Mischpolymerisats mindestens ausreichend ist, um eine gegebenenfalls die Löslichkeitsgrenze überschreitende Menge des Alkohols zu emulgieren, wobei das Entwicklergemisch 1 bis 15 Gew.-% des in Wasser zu weniger als 10 Gew.-% löslichen Alkohols und 0,5 bis 10 Gew.-% des Mischpolymerisats enthält.

2. Entwicklergemisch nach Anspruch 1, dadurch gekennzeichnet, dass es zusätzlich ein ionisches Netzmittel in einer Menge von 0,05 bis 5 Gew.-% enthält.

3. Entwicklergemisch nach Anspruch 1, dadurch gekennzeichnet, dass es zusätzlich ein Salz in einer Menge von 0,1 bis 10 Gew.-% enthält.

4. Entwicklergemisch nach Anspruch 1, dadurch gekennzeichnet, dass es zusätzlich eine Säure in einer Menge von 0,1 bis 8 Gew.-% enthält.

5. Entwicklergemisch nach Anspruch 1, dadurch

gekennzeichnet, dass es zusätzlich in einer Menge von 0,1 bis 10 Gew.-% einen gegebenenfalls partiell veretherten oder veresterten mehrwertigen Alkohol, der zu mindestens 10 Gew.-% wasserlöslich ist, oder einen wasserunlöslichen, vollständig veretherten oder veresterten mehrwertigen Alkohol enthält.

6. Entwicklergemisch nach Anspruch 1, dadurch gekennzeichnet, dass es ein Mischpolymerisat mit hydrophilen Einheiten der Formel I enthält, worin A die Gruppe $N(R_1)R_2$ und $R_2$ eine Acylgruppe mit 1 bis 4 Kohlenstoffatomen bedeutet.

7. Entwicklergemisch nach Anspruch 1, dadurch gekennzeichnet, dass es ein Mischpolymerisat enthält, dessen hydrophobe Einheiten von Alkylestern ungesättigter Carbonsäuren, deren Alkylgruppe 4 bis 30 Kohlenstoffatome hat; von vinylaromatischen Verbindungen oder von Vinylestern aliphatischer Carbonsäuren mit 4 bis 30 Kohlenstoffen abgeleitet sind.

8. Verfahren zum Entwickeln von belichteten lichtempfindlichen Kopierschichten durch Auswaschen zum Reliefbild, dadurch gekennzeichnet, dass man ein Entwicklergemisch nach Anspruch 1 anwendet.

9. Verfahren nach Anspruch 8, dadurch gekennzeichnet, dass man eine lichtempfindliche Kopierschicht verwendet, die ein Diazoniumsalz-Kondensationsprodukt und ein wasserunlösliches Harz enthält.

10. Verfahren nach Anspruch 8 oder 9, dadurch gekennzeichnet, dass man nach dem Auswaschen zum Konservieren der das Reliefbild tragenden Oberfläche überschüssiges Entwicklergemisch auf der Oberfläche antrocknet bzw. antrocknen lässt.

**Claims**

1. A developer mixture for washing out light-sensitive copying layers previously exposed in imagewise manner and containing a polymer of an N-vinyl amine, of vinyl alcohol or of a vinyl alcohol derivative, an alcohol being water-soluble in an amount less than 10% by weight, and water as the main constituent, characterized in that it contains a copolymer which is water-soluble or which can be dispersed in water to form a stable dispersion, composed of

a) hydrophylic units of the formula I

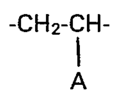

I

wherein

A is O-R or 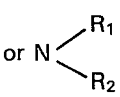

R is a hydrogen atom or a methyl group,
$R_1$ is a hydrogen atom, an alkyl group or an alkoxy alkyl group having 1 to 10 carbon atoms each or an aryl group with 6 to 10 carbon atoms,
$R_2$ is an alkyl group or an acyl group having 1 to 5 carbon atoms, each,

a homopolymer of the hydrophilic units being water-soluble, and of

b) hydrophobic units of vinyl monomers whose homopolymer is water-insoluble and which have an aromatic or a long-chain aliphatic group as the substituent,

the proportion of the hydrophobic units being sufficient to ensure that an 0.1% aqueous solution of said copolymer has a surface tension of not more than 50 mN/m and that the quantity of said copolymer is at least sufficient to emulsify any quantity of alcohol possibly exceeding the solubility limit, and wherein the developer mixture contains 1 to 15% by weight of the alcohol which is water-soluble in an amount less than 10% by weight, and 0.5 to 10% by weight of the copolymer.

2. A developer mixture according to claim 1 characterized in that it contains additionally 0.05 to 5% by weight of an iomic wetting agent.

3. A developer mixture according to claim 1 characterized in that it contains additionally 0.1 to 10% by weight of a salt.

4. A developer mixture according to claim 1 characterized in that it contains additionally 0.1 to 8% by weight of an acid.

5. A developer mixture according to claim 1 characterized in that it contains additionally 0.1 to 10% by weight of a polyvalent alcohol which may be partially etherified or esterified and which is water-soluble to at least 10% by weight, or of a water-insoluble completely etherified or esterified polyvalent alcohol.

6. A developer mixture according to claim 1 characterized in that it contains a copolymer with hydrophilic units of the formula I, wherein A is the group $N(R_1)R_2$, and $R_2$ is an acyl group having between 1 and 4 carbon atoms.

7. A developer mixture according to claim 1 characterized in that it contains a copolymer whose hydrophobic units are derived from alkyl esters of unsaturated carboxylic acids having alkyl groups with 4 to 30 carbon atoms, from vinyl aromatic compounds or from vinyl esters of aliphatic carboxylic acids having 4 to 30 carbon atoms.

8. A process for developing exposed light-sensitive copying layers by washing out to obtain a relief image, characterized in that a developer mixture according to claim 1 is applied.

9. A process according to claim 8 characterized in that a light-sensitive copying layer is applied which contains a diazonium salt condensation product and a water-insoluble resin.

10. A process according to claim 8 or 9 characterized un that after washing out, excess developer mixture is dried or alowed to dry on the plate surface, in order to preserve the suface carrying the relief image.

**Revendications**

1. Mélange révélateur pour le traitement par lavage de couches à copier photosensibles exposées à la lumière selon une image, contenant un produit obtenu par polymérisation d'une N-vinylamine, de l'alcool vinylique ou d'un dérivé de l'alcool vinylique, un alcool ayant une solubilité dans l'eau inférieure à 10% en poids ainsi que de l'eau comme ingrédient principal, caractérisé en ce qu'il contient un copolymère hydrosoluble ou pouvant former une dispersion stable dans l'eau à partir de:

a) des unités hydrophiles de formule I

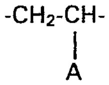 , (I)

où A est O-R ou 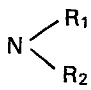 ,

R est un atome d'hydrogène ou un groupe méthyle,

$R_1$ est un atome d'hydrogène, un groupe alkyle ou un groupe alcoxyalkyle ayant chacun de 1 à 10 atomes de carbone ou un groupe aryle ayant de 6 à 10 atomes de carbone, et

$R_2$ est un groupe alkyle ou un groupe acyle ayant chaque fois de 1 à 5 atomes de carbone,

un homopolymère formé à partir des unités hydrophiles étant hydrosoluble, et

b) des unités hydrophobes de monomères vinyliques, dont l'homopolymère est insoluble dans l'eau et qui présentent comme substituant un reste aromatique ou aliphatique à longue chaîne,

la proportion pondérale des unités hydrophobes étant suffisamment importante pour qu'une solution aqueuse à 0,1% du copolymère présente une tension superficielle qui n'est pas supérieure à 50 mN/m, et que la quantité de copolymère soit pour le moins suffisante pour émulsifier une quantité d'alcool éventuellement supérieure à la limite de solubilité, le mélange révélateur contenant entre 1 et 15% en poids de l'alcool dont la solubilité dans l'eau est inférieure à 10% en poids, et entre 0,5 et 10% en poids du copolymère.

2. Mélange révélateur selon la revendication 1, caractérisé en ce qu'il comprend en outre un agent mouillant ionique en une quantité comprise entre 0,05 et 5% en poids.

3. Mélange révélateur selon la revendication 1, caractérisé en ce qu'il contient en outre un sel en une quantité comprise entre 0,1 et 10% en poids.

4. Mélange révélateur selon la revendication 1, caractérisé en ce qu'il comprend en outre un acide en une quantité comprise entre 0,1 et 8% en poids.

5. Mélange révélateur selon la revendication 1, caractérisé en ce qu'il comprend en outre entre 0,1 et 10% en poids d'un alcool polyvalent éventuellement partiellement éthérifié ou estérifié, dont la solubilité dans l'eau n'est pas inférieure à 10% en poids, ou d'un alcool polyvalent insoluble dans l'eau entièrement étherifié ou estérifié.

6. Mélange révélateur selon la revendication 1, caractérisé en ce qu'il comprend un copolymère ayant des unités hydrophiles de formule I dans laquelle A est le groupe $N(R_1)R_2$ et $R_2$ un groupe acyle ayant de 1 à 4 atomes de carbone.

7. Mélange révélateur selon la revendication 1, caractérisé en ce qu'il comprend un copolymère dont les unités hydrophobes sont dérivées d'esters alkyliques d'acides carboxyliques insaturés dont le groupe alkyle possède entre 4 et 30 atomes de carbone, de composés vinylaromatiques ou d'esters vinyliques d'acides carboxyliques aliphatiques ayant de 4 à 40 atomes de carbone.

8. Procédé pour le développement de couches à copier photosensibles exposées à la lumière dans lequel l'image en relief subit un traitement par lavage, caractérisé en ce qu'on emploie un mélange révélateur selon la revendication 1.

9. Procédé selon la revendication 8, caractérisé en ce qu'on emploie une couche à copier photosensible contenant un produit obtenue par condensation d'un sel de diazonium et une résine insoluble dans l'eau.

10. Procédé selon la revendication 8 ou 9, caractérisé en ce qu'après le traitement par lavage, on sèche ou on laisse sécher, le mélange révélateur en excès sur la surface comportant l'image en relief afin d'obtenir un effet de conservation.